# EUROPEAN PATENT APPLICATION

(11) **EP 4 810 963 A1**
(43) Date of publication of application: **23.09.2026**
(21) Application number: 24890128.2
(22) Date of filing: 01.07.2024
(51) Int. Cl.: G01R 19/00, G01R 1/20, H01M 10/42

(54) **HIGH-VOLTAGE SAMPLING CIRCUIT AND BATTERY MANAGEMENT SYSTEM**

(30) Priority: 15.11.2023 CN 202323089415 U
(71) Applicant: Contemporary Amperex Technology Co., Limited, Ningde, Fujian 352100 (CN); Contemporary Amperex Runzhi Software Technology Limited, Ningde, Fujian 352100 (CN)
(72) Inventor: LU, Fangyou, Ningde, Fujian 352100 (CN); ZHANG, Zhenpeng, Ningde, Fujian 352100 (CN); LI, Yutao, Ningde, Fujian 352100 (CN); HUANG, Taiquan, Ningde, Fujian 352100 (CN)
(74) Representative: Ran, Handong
(86) International application number: PCT/CN2024/102996
(87) International publication number: WO 2025/102759

(57) **Abstract**

A high-voltage sampling circuit and a battery management system. The high-voltage sampling circuit (20) comprises a resistor voltage division unit (202), a switch unit (203) and a voltage sampling unit (204). The resistor voltage division unit (202) is configured to perform voltage division on bus voltages at two ends of a high-voltage bus (201) to generate a first voltage signal; and the voltage sampling unit (204) comprises an energy storage component (2041) and an isolation component (2042), and is configured to store energy in the energy storage component (2041) by means of the first voltage signal when the switch unit (203) in a first state, and convert the energy stored in the energy storage component (2041) into a second voltage signal when the switch unit (203) is in a second state, and output a third voltage signal by means of the isolation component (2042) from the second voltage signal.

## Description

### CROSS-REFERENCE TO RELATED APPLICATIONS

The present disclosure is based on and claims priority to the Chinese Patent Application No. 202323089415.4, filed on November 15, 2023 and entitled "HIGH-VOLTAGE SAMPLING CIRCUIT AND BATTERY MANAGEMENT SYSTEM", which is incorporated herein by reference in its entirety.

### TECHNICAL FIELD

The present disclosure relates to the field of high-voltage sampling technology, and in particular, to a high-voltage sampling circuit and a battery management system.

### BACKGROUND

Applications of new energy batteries in life and industry are increasingly widespread, for example, new energy vehicles equipped with batteries have been widely used, and in addition, batteries are increasingly applied in fields such as energy storage.

To ensure safe operation of an electric vehicle, when a battery management system (Battery Management System, BMS) in the electric vehicle operates, it is necessary to monitor various parameters of a traction battery in the electric vehicle, such as temperature, voltage, and current. Among them, the voltage of the traction battery is an important parameter, and it is necessary for the BMS to sample and detect a high voltage between positive and negative busbars of the traction battery through a high-voltage sampling circuit, and to make various actions or adjust parameters in a timely manner based on changes in the current busbar voltage.

In the related art, the high-voltage sampling circuit mainly converts a high voltage into a low-voltage signal through voltage-dividing resistors connected in series between positive and negative busbars, and then the low-voltage signal is sequentially subjected to isolation operation through a sampling chip and an isolation communication chip, and finally transmitted to a microcontroller unit (Microcontroller Unit, MCU). However, such a high-voltage sampling circuit has high costs and a complex circuit, which reduces circuit reliability.

### SUMMARY

The present disclosure mainly provides a high-voltage sampling circuit and a battery management system. High-voltage sampling is performed by controlling energy storage and conversion in an energy storage component through a switch unit. This can reduce circuit costs, simplify the circuit, and improve reliability of the high-voltage sampling circuit.

The technical solutions of the present disclosure are implemented as follows.

In a first aspect, an embodiment of the present disclosure provides a high-voltage sampling circuit, where the high-voltage sampling circuit includes a resistor voltage-dividing unit, a switch unit, and a voltage sampling unit, two ends of the resistor voltage-dividing unit are respectively connected to two ends of a high-voltage busbar, and an output end of the resistor voltage-dividing unit is connected to the voltage sampling unit through the switch unit; where
the resistor voltage-dividing unit is configured to divide a busbar voltage across the two ends of the high-voltage busbar to generate a first voltage signal; and
the voltage sampling unit includes an energy storage component and an isolation component, and is configured to: when the switch unit is in a first state, store energy to the energy storage component based on the first voltage signal; and when the switch unit is in a second state, convert energy stored in the energy storage component into a second voltage signal, and output the second voltage signal as a third voltage signal through the isolation component.

According to the above technical means, when the switch unit is in different states, energy storage and conversion of the energy storage component in the voltage sampling unit is controlled to sample a voltage across the two ends of the high-voltage busbar. This reduces circuit costs and simplifies the circuit, improving reliability of the high-voltage sampling circuit.

In some embodiments, the resistor voltage-dividing unit includes a plurality of voltage-dividing resistors, where
one resistor among the plurality of voltage-dividing resistors is used as a sampling resistor, and output terminals are led out from two ends of the sampling resistor to connect to the switch unit.

According to the above technical means, the two ends of the sampling resistor among the plurality of voltage-dividing resistors are connected to the switch unit to divide a high voltage across the two ends of the high-voltage busbar. This simplifies the circuit of the high-voltage sampling circuit, and reduces costs.

In some embodiments, the plurality of voltage-dividing resistors include a first resistor, a second resistor, and a third resistor, with the second resistor used as the sampling resistor; where
a first end of the first resistor is connected to a positive end of the high-voltage busbar, and a second end of the first resistor is separately connected to a first end of the second resistor and a first input end of the switch unit; and
a first end of the third resistor is separately connected to a second end of the second resistor and a second input end of the switch unit, and a second end of the third resistor is connected to a negative end of the high-voltage busbar.

According to the above technical means, a high voltage across the two ends of the high-voltage busbar is divided through the plurality of voltage-dividing resistors, and the first voltage signal is output from two ends of the second resistor. This simplifies the circuit of the high-voltage sampling circuit, and reduces costs.

In some embodiments, the switch unit includes a first switch group and a second switch group, where
the switch unit being in the first state includes: the first switch group being in an on state and the second switch group being in an off state; and
the switch unit being in the second state includes: the first switch group being in an off state and the second switch group being in an on state.

According to the above technical means, the switch unit may be in different states, so that energy storage and conversion of the energy storage component in the voltage sampling unit is controlled to sample a voltage across the two ends of the high-voltage busbar. This reduces circuit costs and simplifies the circuit, improving reliability of the high-voltage sampling circuit.

In some embodiments, the first switch group includes a first switch and a second switch, and the second switch group includes a third switch and a fourth switch; where
a first end of the first switch serves as the first input end of the switch unit and is separately connected to the second end of the first resistor and the first end of the second resistor, a second end of the first switch is separately connected to a first end of the energy storage component and a first end of the third switch, and a second end of the third switch serves as a first output end of the switch unit and is connected to an input end of the isolation component; and
a first end of the second switch serves as the second input end of the switch unit and is separately connected to the second end of the second resistor and the first end of the third resistor, a second end of the second switch is separately connected to a second end of the energy storage component and a first end of the fourth switch, and a second end of the fourth switch serves as a second output end of the switch unit and is grounded.

According to the above technical means, the switch unit includes the first switch, the second switch, the third switch, and the fourth switch. Opening or closing of the switches in the switch unit is controlled, so that energy storage and conversion of the energy storage component in the voltage sampling unit is controlled to sample a voltage across the two ends of the high-voltage busbar. This reduces circuit costs and simplifies the circuit, improving reliability of the high-voltage sampling circuit.

In some embodiments, the energy storage component includes a first capacitor, where
a first end of the first capacitor serves as the first end of the energy storage component and is connected to a connection line between the first switch and the third switch, and a second end of the first capacitor serves as the second end of the energy storage component and is connected to a connection line between the second switch and the fourth switch.

According to the above technical means, the energy storage component may include the first capacitor for storing, converting, and releasing energy. This reduces circuit costs and simplifies the circuit, improving reliability of the circuit.

In some embodiments, the first capacitor is configured to: when the first switch and the second switch are in an on state and the third switch and the fourth switch are in an off state, store energy to the first capacitor based on a sampling voltage across two ends of the second resistor; or when the first switch and the second switch are in an off state and the third switch and the fourth switch are in an on state, convert energy stored in the first capacitor into the second voltage signal, and transmit the second voltage signal to the isolation component.

According to the above technical means, through storing, converting, and releasing energy by the first capacitor, a voltage across the two ends of the second resistor is transmitted to the isolation component and a device subsequently connected to the isolation component. This reduces circuit costs and simplifies the circuit, improving reliability of the circuit.

In some embodiments, the isolation component includes a voltage follower, where
a non-inverting input end of the voltage follower is connected to the first output end of the switch unit, and an inverting input end of the voltage follower is connected to an output end of the voltage follower for outputting the third voltage signal.

According to the above technical means, a high-voltage side and a low-voltage side of the circuit are isolated by the voltage follower to prevent a high-voltage or dangerous signal from being transmitted to the low-voltage side. This improves safety of the circuit.

In some embodiments, the isolation component includes a voltage follower and a fourth resistor, where
a non-inverting input end of the voltage follower is connected to the first output end of the switch unit, an inverting input end of the voltage follower is connected to a first end of the fourth resistor, and a second end of the fourth resistor is connected to an output end of the voltage follower for outputting the third voltage signal.

According to the above technical means, a high-voltage side and a low-voltage side of the circuit are isolated by the voltage follower and the fourth resistor to prevent a high-voltage or dangerous signal from being transmitted to the low-voltage side. This improves safety of the circuit.

In some embodiments, the resistor voltage-dividing unit further includes a fifth switch, and the fifth switch is connected between the plurality of voltage-dividing resistors, where
the fifth switch is configured to control opening and closing of the resistor voltage-dividing unit to control an operation state of the high-voltage sampling circuit.

According to the above technical means, an embodiment of the present disclosure provides a high-voltage sampling circuit, in which an operation state of the high-voltage sampling circuit is controlled based on the opening and closing of the fifth switch. The fifth switch has low power consumption and costs, and the circuit is simple. This reduces circuit costs and simplifies the circuit, improving reliability of the high-voltage sampling circuit.

In a second aspect, an embodiment of the present disclosure provides a battery management system, where the battery management system includes the high-voltage sampling circuit according to any one of the first aspect and a controller, where
an output end of the high-voltage sampling circuit is connected to the controller for providing a third voltage signal output by the high-voltage sampling circuit to the controller.

According to the above technical means, the sampling circuit is simple, and the controller directly collects a sampling voltage. This can effectively reduce costs of the sampling circuit while simplifying transmission of a sampling signal and improving reliability.

In some embodiments, the controller is further configured to send a control command to a switch in the switch unit, where the control command is used to control the switch in the switch unit to be in an on state or an off state.

According to the above technical means, the controller controls opening and closing of the switch unit. This ensures normal operation of the high-voltage sampling circuit.

The present disclosure provides a high-voltage sampling circuit and a battery management system. When a switch unit is in a first state, an energy storage component stores energy based on a first voltage signal generated by dividing a busbar voltage across two ends of a high-voltage busbar. When the switch unit is in a second state, after energy stored in the energy storage component is converted into a second voltage signal, a third voltage signal is output through the isolation component as a result of high-voltage sampling. In this way, compared with the related art, there is no need to use a dedicated sampling chip, and isolated high-voltage sampling can be achieved only through the energy storage component and the switch unit, thereby simplifying the circuit, reducing circuit complexity; and while circuit costs are effectively reduced, transmission of a sampling signal can also be simplified, thereby improving reliability of the high-voltage sampling circuit.

### BRIEF DESCRIPTION OF DRAWINGS

FIG. 1 is a schematic structural diagram of a high-voltage sampling circuit;
FIG. 2 is a first schematic structural diagram of a high-voltage sampling circuit according to an embodiment of the present disclosure;
FIG. 3 is a second schematic structural diagram of a high-voltage sampling circuit according to an embodiment of the present disclosure;
FIG. 4 is a third schematic structural diagram of a high-voltage sampling circuit according to an embodiment of the present disclosure;
FIG. 5 is a fourth schematic structural diagram of a high-voltage sampling circuit according to an embodiment of the present disclosure;
FIG. 6 is a fifth schematic structural diagram of a high-voltage sampling circuit according to an embodiment of the present disclosure;
FIG. 7 is a sixth schematic structural diagram of a high-voltage sampling circuit according to an embodiment of the present disclosure;
FIG. 8 is a seventh schematic structural diagram of a high-voltage sampling circuit according to an embodiment of the present disclosure;
FIG. 9 is a first schematic structural diagram of a battery management system according to an embodiment of the present disclosure; and
FIG. 10 is a second schematic structural diagram of a battery management system according to an embodiment of the present disclosure.

### DESCRIPTION OF EMBODIMENTS

In order to understand the features and technical contents of the embodiments of the present disclosure in more detail, the implementations of the embodiments of the present disclosure are described in detail below with reference to the accompanying drawings. The accompanying drawings are for reference and illustration only, and are not intended to limit the embodiments of the present disclosure.

Unless otherwise defined, all technical and scientific terms used herein have the same meaning as commonly understood by those skilled in the art to which the present disclosure pertains. The terms used herein are for the purpose of describing the embodiments of the present disclosure only, and are not intended to limit the present disclosure.

In the following description, reference to "some embodiments" describes a subset of all possible embodiments, but it is understood that "some embodiments" may be the same subset or different subsets of all possible embodiments, and may be combined with each other without conflict.

It should also be noted that the terms "first/second/third" in the embodiments of the present disclosure are only used to distinguish similar objects, and do not represent a specific order for the objects. It is understood that "first/second/third" may be interchangeable in terms of specific sequence or order where permitted, so that the embodiments of the present disclosure described herein can be implemented in an order other than that illustrated or described herein.

At present, applications of new energy batteries in life and industry are increasingly widespread. New energy batteries are not only applied to energy storage power systems such as hydropower, thermal power, wind power, and solar power stations, but are also widely applied to electric transportation tools such as electric bicycles, electric motorcycles, and electric vehicles, as well as in many fields such as aerospace. With the continuous expansion of application fields of power batteries, their market demand is also constantly increasing.

In the embodiments of the present disclosure, a battery may be a battery cell (sometimes also referred to as a cell), or a battery may be a battery module or a battery pack including a plurality of battery cells. The battery cell refers to a basic unit capable of realizing mutual conversion between chemical energy and electrical energy, and can be used to form a battery module or a battery pack and supply power to an electric device. The battery cell may be a secondary battery, and the secondary battery refers to a battery cell that can be reused by activating an active material through charging after the battery cell is discharged. The battery cell may be a lithium-ion battery, a sodium-ion battery, a sodium-lithium-ion battery, a lithium metal battery, a sodium metal battery, a lithium-sulfur battery, a magnesium-ion battery, a nickel-hydrogen battery, a nickel-cadmium battery, a lead-acid battery, or the like. This is not limited in the embodiments of the present disclosure.

An electric vehicle is provided with energy and driving force by a traction battery pack, and its working voltage platform is generally between 200 Vdc and 750 Vdc. A direct-current part of the traction battery pack and a related electrical assembly together constitute a high-voltage direct-current busbar of the electric vehicle. During operation of the electric vehicle, the high-voltage direct-current busbar needs to be monitored in real time, and a controller on the electric vehicle performs operation processing and logic protection judgment based on a monitored voltage value.

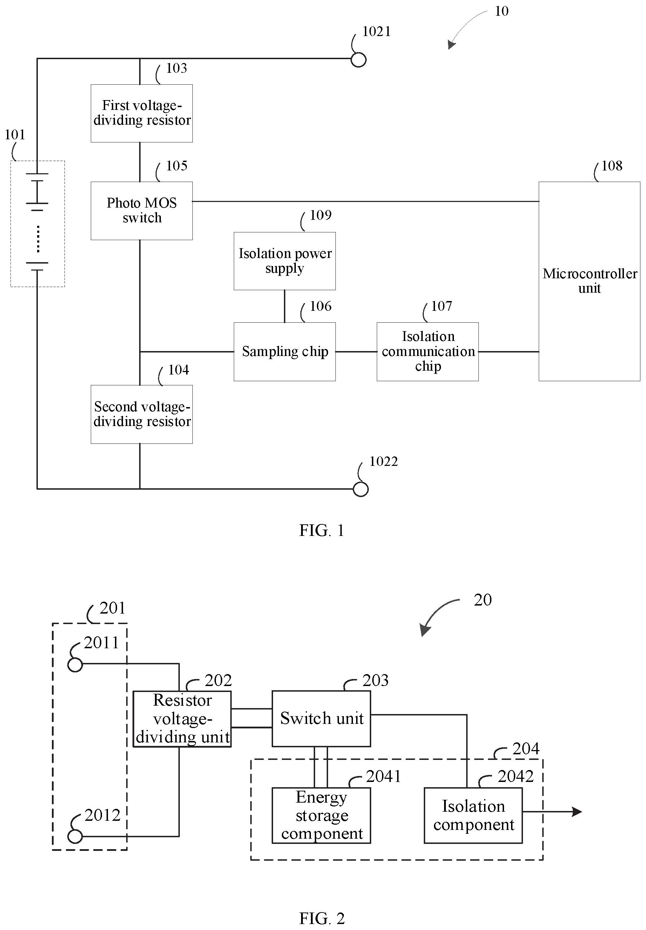

FIG. 1 is a schematic structural diagram of a high-voltage sampling circuit. As shown in FIG. 1, a high-voltage sampling circuit 10 is configured to sample a traction battery 101, where the traction battery 101 may be formed by a plurality of connected battery modules. A plurality of voltage-dividing resistors are connected in series between a battery positive end 1021 and a battery negative end 1022 of the traction battery 101, for example, the plurality of voltage-dividing resistors may include a first voltage-dividing resistor 103 and a second voltage-dividing resistor 104, and one of the voltage-dividing resistors, which illustratively may be the second voltage-dividing resistor 104, is set as a sampling point. In this way, a high-voltage analog signal between the battery positive end 1021 and the battery negative end 1022 of the traction battery 101 is converted into a low-voltage analog signal through the second voltage-dividing resistor 104, and the low-voltage analog signal is input to a sampling chip 106 for further operation processing. For example, the sampling chip 106 converts the low-voltage analog signal into a digital analog signal and sends the signal to an isolation communication chip 107 for isolation, and an isolated communication signal is sent to a microcontroller unit 108. The isolation communication chip 107, as a safety device, is used to ensure isolation between a high-voltage circuit and a low-voltage circuit, that is, ensure safety of voltage signal transmission between a side of the traction battery 101 and a side of the microcontroller unit 108, to avoid damage to the circuit on the side of the microcontroller unit 108 caused by a high-voltage signal.

It should be noted that a photo MOS switch 105 may be an electronic switch used to control conduction or disconnection of a path between the plurality of voltage-dividing resistors and the traction battery 101, and when the high-voltage sampling circuit 10 needs to sleep or an abnormality occurs, the microcontroller unit 108 may set the photo MOS switch 105 to off, to prevent leakage current from entering the sampling chip 106, the isolation communication chip 107, and the like, to avoid damage to the high-voltage sampling circuit 10.

In addition, an isolation power supply 109 may further be provided in the high-voltage sampling circuit 10 for supplying power to the sampling chip 106.

Although in the related art, the above high-voltage sampling circuit 10 may be configured to sample a high voltage of the traction battery 101 to obtain a low-voltage digital signal. However, in such a high-voltage sampling circuit 10, the low-voltage analog signal needs to be converted and transmitted through the sampling chip 106 and the isolation communication chip 107, resulting in a complex transmission process and low circuit reliability. Moreover, in such a high-voltage sampling circuit 10, not only a dedicated sampling chip 106 is required, but also an isolation power supply 109 for supplying power to the sampling chip 106 and the isolation communication chip 107 are required. This results in a complex and costly circuit structure of the high-voltage sampling circuit 10.

Based on the above technical problems, an embodiment of the present disclosure provides a high-voltage sampling circuit and a battery management system. When a switch unit is in different states, energy storage and conversion of an energy storage component in a voltage sampling unit is controlled to sample a voltage across the two ends of a high-voltage busbar. This reduces circuit costs and simplifies the circuit, improving reliability of the high-voltage sampling circuit.

The present disclosure is further described in detail below through the accompanying drawings and specific embodiments.

In an embodiment of the present disclosure, FIG. 2 is a first schematic structural diagram of a high-voltage sampling circuit according to an embodiment of the present disclosure. As shown in FIG. 2, a high-voltage sampling circuit 20 may include a resistor voltage-dividing unit 202, a switch unit 203, and a voltage sampling unit 204. Two ends of the resistor voltage-dividing unit 202 are respectively connected to two ends of a high-voltage busbar 201, and an output end of the resistor voltage-dividing unit 202 is connected to the voltage sampling unit 204 through the switch unit 203.

The high-voltage busbar 201 may include a positive end 2011 of the high-voltage busbar and a negative end 2012 of the high-voltage busbar, and is formed by a direct-current part of a traction battery pack and a related electrical assembly in a BMS, where the electrical assembly may include an on board charger (on board charger, OBC), a vehicle control unit (Vehicle Control Unit, VCU), and the like. It should be noted that the positive end 2011 of the high-voltage busbar may also be referred to as HV+, and the negative end 2012 of the high-voltage busbar may also be referred to as HV-.

It should also be noted that the switch unit 203 may include a plurality of switches, and each switch may be in an opened or closed state.

The resistor voltage-dividing unit 202 is configured to divide a busbar voltage across the two ends of the high-voltage busbar 201 to generate a first voltage signal.

The resistor voltage-dividing unit 202 may include a plurality of resistors connected in series. In an embodiment of the present disclosure, a voltage across the two ends of the high-voltage busbar 201 may be divided through the resistor voltage-dividing unit 202, and one resistor in the resistor voltage-dividing unit 202 is selected as a sampling resistor, and two ends of the sampling resistor are used as output ends of the resistor voltage-dividing unit 202 and connected to the voltage sampling unit 204 through the switch unit 203.

It can be understood that the first voltage signal is a low-voltage signal output by the output end of a specific sampling resistor, namely, the resistor voltage-dividing unit 202, after the resistor voltage-dividing unit 202 divides the high voltage across the two ends of the high-voltage busbar 201.

The voltage sampling unit 204 includes an energy storage component 2041 and an isolation component 2042, and is configured to: when the switch unit 203 is in a first state, store energy to the energy storage component 2041 based on the first voltage signal; and when the switch unit 203 is in a second state, convert energy stored in the energy storage component 2041 into a second voltage signal, and output the second voltage signal as a third voltage signal through the isolation component 2042.

The energy storage component 2041 may be a capacitor configured to quickly convert the first voltage signal into energy for storage, and equalize a voltage across the energy storage component 2041 with a voltage across the two output ends of the resistor voltage-dividing unit 202.

The isolation component 2042 may be a device such as a magnetic coupling isolator, an opto-isolator, or a voltage follower for isolating high and low voltages.

In an embodiment of the present disclosure, a state in which all switches in the switch unit 203 are opened or closed at a certain moment may be referred to as a state of the switch unit 203. It can be understood that, to isolate a high-voltage side and a low-voltage side of the high-voltage sampling circuit 20, that is, to separate the high-voltage busbar 201 from a device subsequently connected to the voltage sampling unit 204, the isolation component 2042 needs to be isolated, and the switch unit 203 needs to be adjusted to different states to disconnect or conduct a circuit between the voltage sampling unit 204 and the high-voltage busbar 201. Illustratively, it is assumed that when the switch unit 203 is in a first state, the circuit between the voltage sampling unit 204 and the high-voltage busbar 201 is conducted, and a circuit between the energy storage component and a subsequently connected circuit is disconnected, so that a high voltage on the high-voltage busbar 201 is divided by the resistor voltage-dividing unit 202, and a first voltage signal is output to and stored in the energy storage component 2041 of the voltage sampling unit 204; or when the switch unit 203 is in a second state, the voltage sampling unit 204 is disconnected from the high-voltage busbar 201, and the circuit between the energy storage component and the subsequently connected circuit is conducted, so that energy stored in the energy storage component 2041 is released in a form of a second voltage signal to the isolation component 2042 through the switch unit 203, and then converted by the isolation component 2042 to output a third voltage signal to a subsequently connected device for analysis and processing.

It can be understood that, to ensure accuracy of the high-voltage sampling result, a voltage value of the first voltage signal, a voltage value of the second voltage signal, and a voltage value of the third voltage signal should be equal.

An embodiment of the present disclosure provides a high-voltage sampling circuit, where when a switch unit is in different states, energy storage and conversion of an energy storage component in a voltage sampling unit is controlled to sample a voltage across two ends of a high-voltage busbar. This reduces circuit costs and simplifies the circuit, improving reliability of the high-voltage sampling circuit.

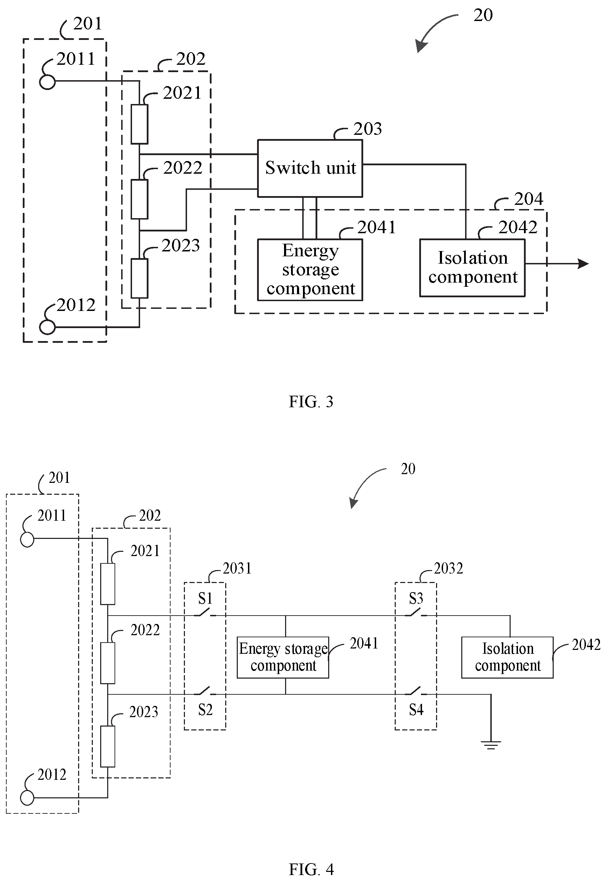

In another embodiment of the present disclosure, based on the high-voltage sampling circuit 20 described in the foregoing embodiment, FIG. 3 is a second schematic structural diagram of a high-voltage sampling circuit according to an embodiment of the present disclosure. As shown in FIG. 3, the resistor voltage-dividing unit 202 may include a plurality of voltage-dividing resistors.

One resistor among the plurality of voltage-dividing resistors is used as a sampling resistor, and output terminals are led out from two ends of the sampling resistor to connect to the switch unit.

As described in the foregoing embodiments, the resistor voltage-dividing unit 202 may include a plurality of resistors connected in series, and based on Ohm's law and the relationship of series resistors, based on an appropriate resistor ratio, an input high voltage may be divided into a desired low voltage, that is, the first voltage signal, and output through two ends of the sampling resistor in the resistor voltage-dividing unit 202.

It can be understood that among the plurality of voltage-dividing resistors in the resistor voltage-dividing unit 202, an appropriate voltage-dividing resistor may be selected based on a voltage range across the two ends of the high-voltage busbar 201, where the sampling resistor may be determined based on a voltage value of the first voltage signal for output.

In some embodiments, with continued reference to FIG. 3, the plurality of voltage-dividing resistors may include a first resistor 2021, a second resistor 2022, and a third resistor 2023, with the second resistor 2022 used as the sampling resistor.

It should be noted that FIG. 3 in the embodiments of the present disclosure illustrates an example where the resistor voltage-dividing unit 202 includes three voltage-dividing resistors, and in actual use, a quantity of voltage-dividing resistors in the resistor voltage-dividing unit 202 may be adjusted according to a specific condition or requirement.

A first end of the first resistor 2021 is connected to a positive end 2011 of the high-voltage busbar, and a second end of the first resistor 2021 is separately connected to a first end of the second resistor 2022 and a first input end of the switch unit 203. A first end of the third resistor 2023 is separately connected to a second end of the second resistor 2022 and a second input end of the switch unit 203, and a second end of the third resistor 2023 is connected to a negative end 2012 of the high-voltage busbar.

In an embodiment of the present disclosure, the second resistor 2022 may be used as the sampling resistor, with output terminals at two ends of the second resistor 2022 respectively connected to the first input end of the switch unit 203 and the second input end of the switch unit 203. In this way, a voltage across the two ends of the second resistor 2022 serves as the first voltage signal, which is input to and stored in the energy storage component 2041 through the switch unit 203 when the switch unit is in a first state.

It should be noted that, in an embodiment of the present disclosure, a resistance value of the first resistor 2021 may be 4M, a resistance value of the second resistor 2022 may be 80K, and a resistance value of the third resistor 2023 may be 4M. Depending on specific usage scenarios, the resistance values of the first resistor 2021, the second resistor 2022, and the third resistor 2023 may be appropriately changed. In addition, when the resistance values of the plurality of voltage-dividing resistors change, other resistors may alternatively be used as the sampling resistor.

An embodiment of the present disclosure provides a high-voltage sampling circuit, where a high voltage across two ends of a high-voltage busbar is divided through a plurality of voltage-dividing resistors, and a first voltage signal is output from two ends of a sampling resistor, so that a circuit of the high-voltage sampling circuit is simple and therefore the costs are reduced.

In another embodiment of the present disclosure, based on the high-voltage sampling circuit 20 described in the foregoing embodiments, FIG. 4 is a third schematic structural diagram of a high-voltage sampling circuit according to an embodiment of the present disclosure. As shown in FIG. 4, the switch unit 203 may include a first switch group 2031 and a second switch group 2032.

The switch unit 203 being in a first state includes: the first switch group 2031 being in an on state and the second switch group 2032 being in an off state.

In an embodiment of the present disclosure, take the second resistor 2022 as the sampling resistor as an example. When the switch unit 203 is in the first state, the first switch group 2031 is closed, and the second switch group 2032 is opened, so that the sampling circuit 2032 is connected to an energy storage component 2041, and a first voltage signal output from two ends of the second resistor 2022 is input to and stored in the energy storage component 2041.

The switch unit 203 being in a second state includes: the first switch group 2031 being in an off state and the second switch group 2032 being in an on state.

In an embodiment of the present disclosure, when the switch unit 203 is in the second state, the first switch group 2031 is opened, and the second switch group 2032 is closed, so that the energy storage component 2041 is connected to an isolation component 2042, and energy stored in the energy storage component 2041 is converted into a second voltage signal and transmitted to the isolation component 2042.

In some embodiments, the first switch group 2031 includes a first switch S1 and a second switch S2, and the second switch group 2032 includes a third switch S3 and a fourth switch S4.

A first end of the first switch S1 serves as a first input end of the switch unit 203 and is separately connected to a second end of a first resistor 2021 and a first end of a second resistor 2022, a second end of the first switch S1 is separately connected to a first end of the energy storage component 2041 and a first end of the third switch S3, and a second end of the third switch S3 serves as a first output end of the switch unit 203 and is connected to an input end of the isolation component 2042.

A first end of the second switch S2 serves as a second input end of the switch unit 203 and is separately connected to a second end of the second resistor 2022 and a first end of the third resistor 2023, a second end of the second switch S2 is separately connected to a second end of the energy storage component 2041 and a first end of the fourth switch S4, and a second end of the fourth switch S4 serves as a second output end of the switch unit 203 and is grounded.

It should be noted that opening or closing of the first switch S1, the second switch S2, the third switch S3, and the fourth switch S4 may be controlled by an MCU in a BMS. The MCU may control duration in which the first switch group 2031 is on or off and duration in which the second switch group 2032 is on or off is controlled based on a capacity of the energy storage component 2041, so as to control a time for energy storage and energy release of the energy storage component 2041.

In an embodiment of the present disclosure, when the switch unit 203 is in the first state, the first switch S1 and the second switch S2 are closed, and the third switch S3 and the fourth switch S4 are opened, so that the sampling resistor, that is, the second resistor 2022, is connected in parallel with the energy storage component 2041, equalizing a voltage value across two ends of the sampling resistor and a voltage value across the two ends of the energy storage component 2041. In this way, the first voltage signal output from the two ends of the sampling resistor is transmitted to and stored in the energy storage component 2041 through the first switch S1 and the second switch S2 separately. Based on the control of the MCU, the switch unit 203 stays in the first state until the energy storage component 2041 is fully charged.

In an embodiment of the present disclosure, when the switch unit 203 is in the first state, the first switch S1 and the second switch S2 are opened, and the third switch S3 and the fourth switch S4 are closed, so that one end of the energy storage component 2041 is grounded, and another end is connected to the isolation component 2042. In this way, energy stored in the energy storage component 2041 is converted into the second voltage signal and released toward the isolation component 2042, and output after passing through the isolation component 2042. Based on the control of the MCU, the switch unit 203 stays in the second state until energy in the energy storage component 2041 is fully released.

It can be understood that, in an embodiment of the present disclosure, since the voltage value of the first voltage signal is equal to the voltage value across the two ends of the energy storage component 2041, the voltage value of the second voltage signal output when the energy storage component 2041 releases energy is equal to the voltage value of the first voltage signal.

It should be noted that the first switch S1, the second switch S2, the third switch S3, and the fourth switch S4 may be knife switches, MOS transistors, or other devices with a function of controlling circuit conduction or disconnection.

An embodiment of the present disclosure provides a high-voltage sampling circuit, where the switch unit includes a first switch, a second switch, a third switch, and a fourth switch. Opening or closing of the switches in the switch unit is controlled to set the switch unit to different states, so that energy storage and conversion of an energy storage component in a voltage sampling unit is controlled to sample a voltage across two ends of a high-voltage busbar. This reduces circuit costs and simplifies the circuit, improving reliability of the high-voltage sampling circuit.

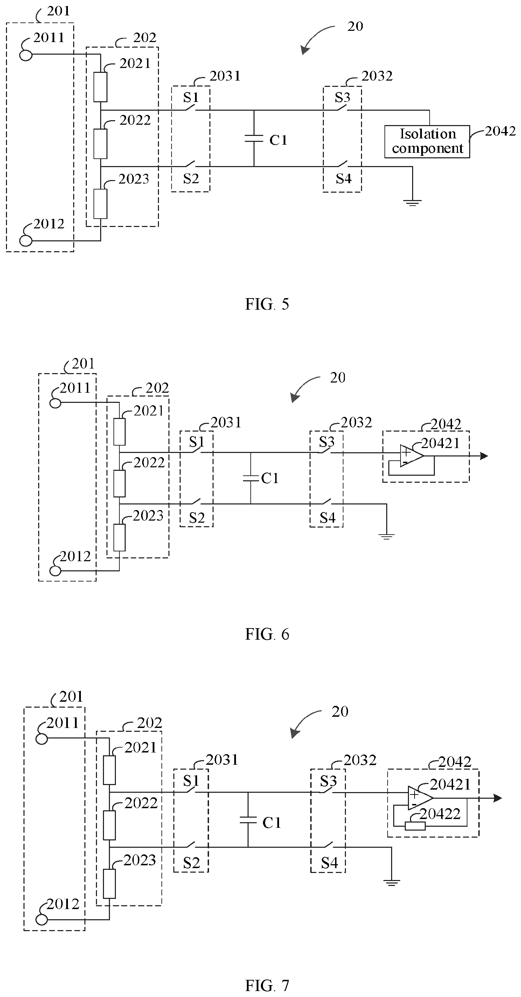

In another embodiment of the present disclosure, based on the high-voltage sampling circuit 20 described in the foregoing embodiments, FIG. 5 is a fourth schematic structural diagram of a high-voltage sampling circuit according to an embodiment of the present disclosure. As shown in FIG. 5, the energy storage component 2041 may be a first capacitor C1.

A first end of the first capacitor C1 serves as the first end of the energy storage component and is connected to a connection line between the first switch S1 and the third switch S3, and a second end of the first capacitor C1 serves as the second end of the energy storage component and is connected to a connection line between the second switch S2 and the fourth switch S4.

As shown in FIG. 5, when the energy storage component 2041 is the first capacitor C1, in this embodiment of the present disclosure, the first capacitor C1 is connected in parallel with the second resistor 2022, and the first voltage signal is output through the second resistor 2022 to the first capacitor C1 for energy storage until the first capacitor C1 is fully charged.

It should be noted that the energy storage component 2041 may alternatively be formed by a plurality of capacitors connected in parallel, or a plurality of capacitors connected in series, or may be formed by other devices capable of storing energy. This may be adaptively adjusted according to specific usage scenarios.

In an embodiment of the present disclosure, a capacitance value of the first capacitor C1 may be 100 nF, and the capacitance value of the first capacitor C1 may also be adaptively adjusted according to different voltage values of the first voltage signal. However, to ensure the accuracy of the high-voltage sampling circuit, the capacitance value of the first capacitor C1 is greater than the voltage value of the first voltage signal to avoid energy overflow of the first voltage signal when the first capacitor C1 stores energy based on the first voltage signal.

In some embodiments, with continued reference to FIG. 5, the first capacitor C1 is configured to: when the first switch S1 and the second switch S2 are in the on state and the third switch S3 and the fourth switch S4 are in the off state, store energy to the first capacitor C1 based on a sampling voltage across the two ends of the second resistor 2022; and when the first switch S1 and the second switch S2 are in the off state and the third switch S3 and the fourth switch S4 are in the on state, convert the energy stored in the first capacitor C1 into the second voltage signal and transmit the second voltage signal to the isolation component 2042.

As described in the foregoing embodiments, the second resistor 2022 is the sampling resistor in the resistor voltage-dividing unit 202, and a voltage value of the sampling voltage across the two ends of the second resistor 2022 is equal to the voltage value of the first voltage signal. In this way, when the switch unit is in the first state, that is, the first switch S1 and the second switch S2 are in the on state and the third switch S3 and the fourth switch S4 are in the off state, the first capacitor C1 is connected in parallel with the second resistor 2022, the first capacitor C1 is disconnected from the isolation component 2042 and a device subsequently connected to the isolation component 2042, and the second resistor 2022 outputs the first voltage signal to the first capacitor C1, causing the first capacitor C1 to store energy. When the first capacitor C1 is fully charged, the switch unit is controlled to be in the second state, that is, the first switch S1 and the second switch S2 are in the off state and the third switch S3 and the fourth switch S4 are in the on state, the first capacitor C1 is disconnected from the second resistor 2022, one end of the first capacitor C1 is grounded, and another end of the first capacitor C1 is connected to the isolation component 2042, converting the energy stored in the first capacitor C1 into the second voltage signal and transmitting the signal to the isolation component 2042.

An embodiment of the present disclosure provides a high-voltage sampling circuit, where the energy storage component may be the first capacitor. Through storing, converting, and releasing energy by the first capacitor, a voltage across the two ends of the second resistor is transmitted to the isolation component and a device subsequently connected to the isolation component. This reduces circuit costs and simplifies the circuit, improving reliability of the circuit.

In still another embodiment of the present disclosure, based on the high-voltage sampling circuit 20 described in the foregoing embodiments, the isolation component 2042 is mainly configured to separate a high-voltage side and a low-voltage side of the circuit, for example, may be an isolation communication chip, a magnetic coupling isolator, an opto-isolator, a voltage follower, or the like.

For example, the isolation component 2042 is a voltage follower. In a possible implementation, FIG. 6 is a fifth schematic structural diagram of a high-voltage sampling circuit according to an embodiment of the present disclosure. As shown in FIG. 6, the isolation component 2042 may include a voltage follower 20421.

A non-inverting input end of the voltage follower 20421 is connected to the first output end of the switch unit, and an inverting input end of the voltage follower 20421 is connected to an output end of the voltage follower 20421 for outputting the third voltage signal.

The voltage follower 20421 may be a device whose output voltage changes following a change in an input voltage. The voltage follower 20421 has a high input impedance and low output impedance, and the voltage follower 20421 presents a high impedance state to a preceding circuit and a low impedance state to a subsequent circuit. This enables the output voltage to approximate the amplitude of the input voltage, allowing the voltage of the preceding stage to be output without loss. Disposing the voltage follower 20421 between the high-voltage side and the low-voltage side of the high-voltage sampling circuit can effectively isolate the impact caused by direct connection between the high-voltage side and the low-voltage side of the circuit, providing isolation and buffering.

In an embodiment of the present disclosure, when the switch unit is in the second state, the first switch group 2031 is off, and the second switch group 2032 is on, the energy storage component 2041 converts stored energy into the second voltage signal and transmits the second voltage signal to the voltage follower 20421 through the second switch group 2032, and after receiving the second voltage signal at the non-inverting input end of the voltage follower 20421, the third voltage signal is output through the output end to a subsequent circuit connected to the voltage follower 20421.

For example, the isolation component 2042 is a voltage follower. In another possible implementation, FIG. 7 is a sixth schematic structural diagram of a high-voltage sampling circuit according to an embodiment of the present disclosure. As shown in FIG. 7, the isolation component 2042 may further include a voltage follower 20421 and a fourth resistor 20422.

A non-inverting input end of the voltage follower 20421 is connected to the first output end of the switch unit, an inverting input end of the voltage follower 20421 is connected to a first end of the fourth resistor 20422, and a second end of the fourth resistor 20422 is connected to an output end of the voltage follower 20421 for outputting the third voltage signal.

It can be understood that, to improve an output current capability of the voltage follower 20421 or limit current, a fourth resistor 20422 may be added to a feedback loop of the voltage follower 20421, which may change an output impedance of the voltage follower 20421 to a certain extent and change a current amplification factor.

It should be noted that the isolation component 2042 may also formed by other components, such as a magnetic coupling isolator, an opto-isolator, or a transformer. Examples are not exhaustively listed in this embodiment of the present disclosure.

An embodiment of the present disclosure provides a high-voltage sampling circuit, in which a high-voltage side and a low-voltage side of the circuit are isolated through the isolation component to prevent a high-voltage or dangerous signal from being transmitted to the low-voltage side. This improves safety of the circuit.

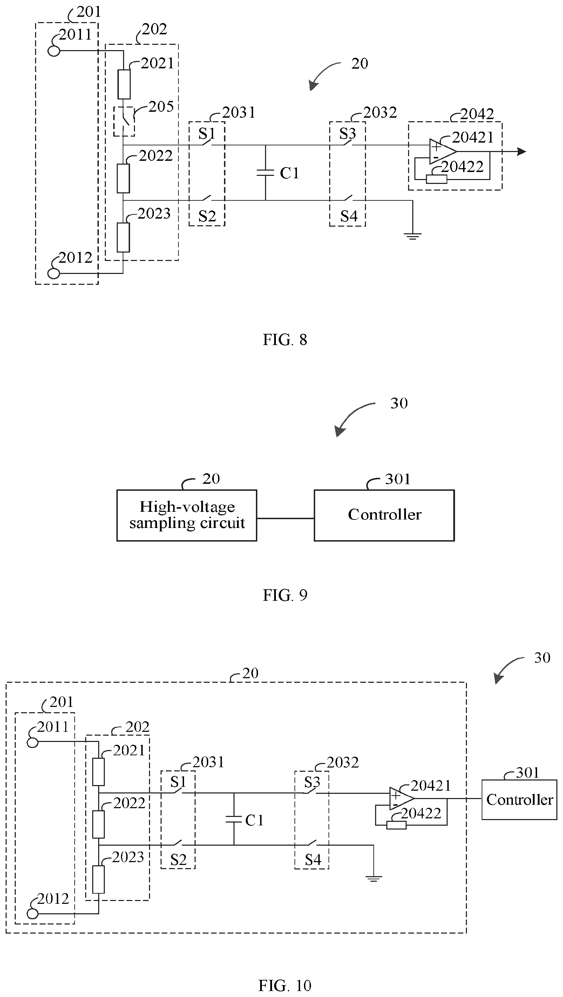

In yet another embodiment of the present disclosure, based on the high-voltage sampling circuit 20 described in the foregoing embodiments, FIG. 8 is a seventh schematic structural diagram of a high-voltage sampling circuit according to an embodiment of the present disclosure. As shown in FIG. 8, the resistor voltage-dividing unit 202 may further include a fifth switch 205, and the fifth switch 205 is connected between the plurality of voltage-dividing resistors.

The fifth switch 205 is configured to control opening and closing of the resistor voltage-dividing unit 202 to control an operation state of the high-voltage sampling circuit 20.

It should be noted that the operation state of the high-voltage sampling circuit 20 may refer to a sampling state or a power-off state of the high-voltage sampling circuit 20. When the fifth switch 205 is on, the resistor voltage-dividing unit 202 is on, and in this case, the high-voltage sampling circuit 20 is in the sampling state. When the fifth switch 205 is off, the resistor voltage-dividing unit 202 is off, and in this case, the high-voltage sampling circuit 20 is in the power-off state.

The fifth switch 205 may be a device such as a photo MOS switch, a high-voltage isolation switch, or a field effect transistor, and controls the operation state of the high-voltage sampling circuit 20 by controlling the conduction and disconnection between the high-voltage busbar and the resistor voltage-dividing unit 202.

In an embodiment of the present disclosure, the fifth switch 205 is disposed between the first resistor 2021 and the second resistor 2022. It can be understood that the fifth switch 205 may alternatively be disposed between the first resistor 2021 and the positive end 2011 of the high-voltage busbar, or at other positions capable of controlling the operation state of the high-voltage sampling circuit 20.

An embodiment of the present disclosure provides a high-voltage sampling circuit, in which an operation state of the high-voltage sampling circuit is controlled based on the opening and closing of the fifth switch. The fifth switch has low power consumption and costs, and the circuit is simple. This reduces circuit costs and simplifies the circuit, improving reliability of the high-voltage sampling circuit.

In still yet another embodiment of the present disclosure, FIG. 9 is a first schematic structural diagram of a battery management system according to an embodiment of the present disclosure. As shown in FIG. 9, the battery management system 30 includes the high-voltage sampling circuit 20 as described in the foregoing embodiments and a controller 301.

An output end of the high-voltage sampling circuit 20 is connected to the controller 301 for providing a third voltage signal output by the high-voltage sampling circuit 20 to the controller 301.

The controller 301 may be an MCU or another device with computing and processing functions. Examples are not exhaustively listed in the present disclosure.

The high-voltage sampling circuit 20 converts a busbar voltage across two ends of a high-voltage busbar into a third voltage signal through the resistor voltage-dividing unit and the voltage sampling unit, and outputs the signal to the controller 301. The controller 301 may determine a voltage value of the busbar voltage across the two ends of the high-voltage busbar based on the third voltage signal, to further determine an operation state of the traction battery, or determine a capacity of the traction battery, or the like.

An embodiment of the present disclosure provides a battery management system, where a high-voltage sampling circuit is simple, and a controller directly collects a sampling voltage. This can effectively reduce costs of the sampling circuit while simplifying transmission of a sampling signal and improving reliability.

In another embodiment of the present disclosure, based on the foregoing battery management system 30, an operation process of the battery management system 30 is described below by using a specific application scenario as an example in which the resistor voltage-dividing unit 202 includes a 4M resistor, an 80K resistor, and a 4M resistor, and a first capacitor C1 is 100 nF.

Based on this application scenario, FIG. 10 is a second schematic structural diagram of a battery management system according to an embodiment of the present disclosure. As shown in FIG. 10, the battery management system 30 may include a high-voltage sampling circuit 20 and a controller 301. The controller 301 is further configured to send a control command to a switch in the switch unit 203, where the control command is used to control the switch in the switch unit 203 to be in an on state or an off state.

As shown in FIG. 10, the high-voltage sampling circuit 20 may include the resistor voltage-dividing unit 202, a first switch group 2031, a second switch group 2032, a first capacitor C1, a voltage follower 20421, and a fourth resistor 20422. The resistor voltage-dividing unit 202 includes a first resistor 2021 (for example, a 4M resistor), a second resistor 2022 (for example, an 80K resistor), and a third resistor 2023 (for example, a 4M resistor), where the resistance values may be modified according to a specific solution, and the second resistor 2022 may be selected as a sampling resistor; and the first resistor 2021, the second resistor 2022, and the third resistor 2023 are connected in series between a positive end 2011 and the negative end 2012 of the high-voltage busbar 201. In addition, the first switch group 2031 and the second switch group 2032 form the switch unit, which may specifically include a first switch S1, a second switch S2, a third switch S3, and a fourth switch S4. The first capacitor C1 serves as an energy storage component with a capacitance value of 100 nF. An output end of the voltage follower 20421 may be connected to the controller 301.

In an embodiment of the present application, the resistor voltage-dividing unit 202 includes two 4M voltage-dividing resistors and one 80K sampling resistor 2032. The 80K sampling resistor divides voltage with the two 4M voltage-dividing resistors. The first capacitor C1 is connected in parallel with the 80K sampling resistor. When the first switch S1 and the second switch S2 are closed, and the third switch S3 and the fourth switch S4 are opened, the first capacitor C1 is fully charged, and a full-charge voltage is equal to a voltage across two ends of the 80K sampling resistor. When the first switch S1 and the second switch S2 are opened, and the third switch S3 and the fourth switch S4 are closed, the first capacitor C1 is connected to the voltage follower 20421, and the voltage across the two ends of the 80K sampling resistor is transmitted to the controller through the voltage follower 20421. When the first switch S1 and the second switch S2 are opened, the voltage sampling unit is disconnected from a high-voltage loop. Since the voltage follower 20421 has a high input impedance and low output impedance, isolation between high and low voltages can be achieved.

It should be noted that the controller 301 may further be configured to control the switch unit, that is, to turn on or off the first switch group 2031 in the switch unit in the foregoing embodiments, including the first switch S1 and the second switch S2, and turn on or off the second switch group 2032, including the third switch S3 and the fourth switch S4. The controller 301 may preset a time period for energy storage and release of the energy storage component 2041 based on a different capacity of the energy storage component 2041 in the voltage sampling unit, that is, an on/off time period for the first switch group 2031 and the second switch group 2032. Illustratively, at a moment when a time period for energy storage starts, the controller 301 sends a control command to a switch in the switch unit to turn on the first switch group 2031 and turn off the second switch group 2032, and the energy storage component 2041 stores energy; at a moment when the time period for energy storage ends, that is, a time period for energy release starts, the controller 301 sends a control command to the switch in the switch unit 203 to turn off the first switch group 2031 and turn on the second switch group 2032, and the energy storage component 2041 releases energy.

In addition, the controller 301 may further be configured to control opening and closing of the fifth switch in the above embodiments, so as to control the operation state of the high-voltage sampling circuit 20. The high-voltage sampling circuit 20 is powered off when high-voltage sampling is not needed, and the high-voltage sampling circuit 20 enters the sampling state when high-voltage sampling is needed, thereby saving energy consumption.

An embodiment of the present disclosure provides a battery management system, in which a controller controls opening and closing of a switch unit. This ensures normal operation of a high-voltage sampling circuit.

The above embodiments are only preferred embodiments of the present disclosure, and are not intended to limit the protection scope of the present disclosure. Any modifications, equivalent substitutions, improvements, and the like made within the spirit and principles of the present disclosure should be included in the protection scope of the present disclosure.

An embodiment of the present disclosure further provides a computer program product including instructions, and when the computer program product is run on a computer, the computer is enabled to execute the steps in the thermal control method provided in the above method embodiments.

It should be understood that the descriptions of the above storage medium and device embodiments are similar to the descriptions of the above method embodiments, and have similar beneficial effects as the method embodiments. For technical details not disclosed in the storage medium, storage medium, and device embodiments of the present disclosure, refer to the descriptions of the method embodiments of the present disclosure for understanding.

It should be understood that "one embodiment", "an embodiment", or "some embodiments" mentioned throughout the specification means that a specific feature, structure, or characteristic related to the embodiment is included in at least one embodiment of the present disclosure. Therefore, "in one embodiment", "in an embodiment", or "in some embodiments" appearing throughout the specification does not necessarily refer to the same embodiment. In addition, these specific features, structures, or characteristics may be combined in one or more embodiments in any suitable manner. It should be understood that, in various embodiments of the present disclosure, the sequence numbers of the above processes do not mean the order of execution, and the execution order of the processes should be determined by their functions and internal logic, and should not constitute any limitation on the implementation process of the embodiments of the present disclosure. The above sequence numbers of the embodiments of the present disclosure are for description only, and do not represent the advantages and disadvantages of the embodiments. The above descriptions of various embodiments tend to emphasize the differences between the embodiments, and mutual reference may be made for the same or similar parts. For brevity, the details are not repeated herein.

It should also be noted that, in the present disclosure, the terms "include", "comprise", or any other variants thereof are intended to cover non-exclusive inclusion, so that a process, method, article, or device including a series of elements includes not only those elements, but also other elements not explicitly listed, or elements inherent to such a process, method, article, or device. Without further limitations, an element defined by the phrase "including a..." does not exclude the presence of other identical elements in the process, method, article, or device including the element.

The above sequence numbers of the embodiments of the present disclosure are for description only, and do not represent the advantages and disadvantages of the embodiments.

The methods disclosed in several method embodiments provided by the present disclosure can be arbitrarily combined without conflict to obtain new method embodiments.

The features disclosed in several product embodiments provided by the present disclosure can be arbitrarily combined without conflict to obtain new product embodiments.

The features disclosed in several method or device embodiments provided by the present disclosure can be arbitrarily combined without conflict to obtain new method embodiments or device embodiments.

The above implementations are only specific implementations of the present disclosure, but the protection scope of the present disclosure is not limited thereto. Any person skilled in the art can easily think of changes or substitutions within the technical scope disclosed in the present disclosure, which should be covered within the protection scope of the present disclosure. Therefore, the protection scope of the present disclosure should be subject to the protection scope of the claims.

The above are only preferred embodiments of the present disclosure, and are not intended to limit the protection scope of the present disclosure. Any modifications, equivalent substitutions, improvements, and the like made within the spirit and principles of the present disclosure should be included in the protection scope of the present disclosure.

## Claims

1. A high-voltage sampling circuit, comprising a resistor voltage-dividing unit, a switch unit, and a voltage sampling unit, wherein two ends of the resistor voltage-dividing unit are respectively connected to two ends of a high-voltage busbar, and an output end of the resistor voltage-dividing unit is connected to the voltage sampling unit through the switch unit, wherein:
the resistor voltage-dividing unit is configured to divide a busbar voltage across the two ends of the high-voltage busbar to generate a first voltage signal; and
the voltage sampling unit comprises an energy storage component and an isolation component, and is configured to:
when the switch unit is in a first state, store energy to the energy storage component based on the first voltage signal; and
when the switch unit is in a second state, convert energy stored in the energy storage component into a second voltage signal, and output the second voltage signal as a third voltage signal through the isolation component.

2. The high-voltage sampling circuit according to claim 1, wherein the resistor voltage-dividing unit comprises a plurality of voltage-dividing resistors, wherein:
one resistor among the plurality of voltage-dividing resistors is used as a sampling resistor, and output terminals are led out from two ends of the sampling resistor to connect to the switch unit.

3. The high-voltage sampling circuit according to claim 2, wherein the plurality of voltage-dividing resistors comprise a first resistor, a second resistor, and a third resistor, with the second resistor used as the sampling resistor, wherein:
a first end of the first resistor is connected to a positive end of the high-voltage busbar, and a second end of the first resistor is separately connected to a first end of the second resistor and a first input end of the switch unit; and
a first end of the third resistor is separately connected to a second end of the second resistor and a second input end of the switch unit, and a second end of the third resistor is connected to a negative end of the high-voltage busbar.

4. The high-voltage sampling circuit according to claim 3, wherein the switch unit comprises a first switch group and a second switch group, wherein:
when the switch unit is in the first state, the first switch group is in an on state and the second switch group is in an off state; and
when the switch unit is in the second state, the first switch group is in an off state and the second switch group is in an on state.

5. The high-voltage sampling circuit according to claim 4, wherein the first switch group comprises a first switch and a second switch, and the second switch group comprises a third switch and a fourth switch, wherein:
a first end of the first switch serves as the first input end of the switch unit and is separately connected to the second end of the first resistor and the first end of the second resistor, a second end of the first switch is separately connected to a first end of the energy storage component and a first end of the third switch, and a second end of the third switch serves as a first output end of the switch unit and is connected to an input end of the isolation component; and
a first end of the second switch serves as the second input end of the switch unit and is separately connected to the second end of the second resistor and the first end of the third resistor, a second end of the second switch is separately connected to a second end of the energy storage component and a first end of the fourth switch, and a second end of the fourth switch serves as a second output end of the switch unit and is grounded.

6. The high-voltage sampling circuit according to claim 5, wherein the energy storage component comprises a first capacitor, wherein:
a first end of the first capacitor serves as the first end of the energy storage component and is connected to a connection line between the first switch and the third switch, and a second end of the first capacitor serves as the second end of the energy storage component and is connected to a connection line between the second switch and the fourth switch.

7. The high-voltage sampling circuit according to claim 6, wherein the first capacitor is configured to:
when the first switch and the second switch are in an on state and the third switch and the fourth switch are in an off state, store energy to the first capacitor based on a sampling voltage across two ends of the second resistor.

8. The high-voltage sampling circuit according to claim 6, wherein the first capacitor is further configured to:
when the first switch and the second switch are in an off state and the third switch and the fourth switch are in an on state, convert energy stored in the first capacitor into the second voltage signal, and transmit the second voltage signal to the isolation component.

9. The high-voltage sampling circuit according to any one of claims 1 to 8, wherein the isolation component comprises a voltage follower, wherein:
a non-inverting input end of the voltage follower is connected to the first output end of the switch unit, and an inverting input end of the voltage follower is connected to an output end of the voltage follower for outputting the third voltage signal.

10. The high-voltage sampling circuit according to any one of claims 1 to 8, wherein the isolation component comprises a voltage follower and a fourth resistor, wherein:
a non-inverting input end of the voltage follower is connected to the first output end of the switch unit, an inverting input end of the voltage follower is connected to a first end of the fourth resistor, and a second end of the fourth resistor is connected to an output end of the voltage follower for outputting the third voltage signal.

11. The high-voltage sampling circuit according to any one of claims 1 to 10, wherein the resistor voltage-dividing unit further comprises a fifth switch connected between the plurality of voltage-dividing resistors in the resistor voltage-dividing unit, wherein:
the fifth switch is configured to enable or disable the resistor voltage-dividing unit to control an operation state of the high-voltage sampling circuit.

12. The high-voltage sampling circuit according to any one of claims 1 to 10, wherein the resistor voltage-dividing unit further comprises a fifth switch connected between the voltage-dividing resistors in the resistor voltage-dividing unit and the positive end of the high-voltage busbar, wherein:
the fifth switch is configured to enable or disable the resistor voltage-dividing unit to control an operation state of the high-voltage sampling circuit.

13. A battery management system, comprising the high-voltage sampling circuit according to any one of claims 1 to 12 and a controller, wherein:
an output end of the high-voltage sampling circuit is connected to the controller for providing a third voltage signal output by the high-voltage sampling circuit to the controller.

14. The battery management system according to claim 13, wherein the controller is further configured to send a control command to a switch in the switch unit, wherein the control command is used to control a switch in the switch unit to be in an on state or an off state.
